# EUROPEAN PATENT SPECIFICATION

(11) **EP 4 095 916 B1**
(45) Date of publication and mention of the grant of the patent: **02.04.2025**
(21) Application number: 21203951.5
(22) Date of filing: 21.10.2021
(51) Int. Cl.: H10K 30/57, H10K 85/50, H10F 10/14, H10F 10/19

(54) **TWO TERMINAL TANDEM SOLAR CELL**
TANDEMSOLARZELLE MIT ZWEI ANSCHLÜSSEN
CELLULE SOLAIRE TANDEM À DEUX BORNES

(30) Priority: 28.05.2021 LT 2021524
(43) Date of publication of application: 30.11.2022
(73) Proprietor: Valstybinis Moksliniu Tyrimu Institutas Fiziniu Ir Technologijos Mokslu Centras, 02300 Vilnius (LT)
(72) Inventor: ASMONTAS, Steponas, 08411 Vilnius (LT); GRADAUSKAS, Jonas, 10308 Vilnius (LT); GRIGUCEVICIENE, Asta, 07140 Vilnius (LT); LEINARTAS, Konstantinas, 08413 Vilnius (LT); PETRAUSKAS, Kazimieras, 03135 Vilnius (LT); STAISIUNAS, Laurynas, 10304 Vilnius (LT); SUZIEDELIS, Algirdas, 04207 Vilnius (LT); SILENAS, Aldis, 03221 Vilnius (LT); SIRMULIS, Edmundas, 06153 Vilnius (LT)
(74) Representative: Draugeliene, Virgina Adolfina

(56) References cited:
- CN-A- 103 682 153
- ZHENG JIANGHUI ET AL: "Large area efficient interface layer free monolithic perovskite/homo-junction-silicon tandem solar cell with over 20% efficiency", ENERGY & ENVIRONMENTAL SCIENCE, vol. 11, no. 9, 25 June 2018 (2018-06-25), Cambridge, pages 2432 - 2443, XP055887003, ISSN: 1754-5692, DOI: 10.1039/C8EE00689J
- LIAO YUQIN ET AL: "Hole-transporting layer-free inverted planar mixed lead-tin perovskite-based solar cells", FRONTIERS OF OPTOELECTRONICS, HIGHER EDUCATION PRESS, HEIDELBERG, vol. 10, no. 2, 9 June 2017 (2017-06-09), pages 103 - 110, XP036507112, ISSN: 2095-2759, [retrieved on 20170609], DOI: 10.1007/S12200-017-0716-6
- DONG HOE KIM ET AL: "Niobium Doping Effects on TiO 2 Mesoscopic Electron Transport Layer-Based Perovskite Solar Cells", CHEMSUSCHEM, vol. 8, no. 14, 17 April 2015 (2015-04-17), DE, pages 2392 - 2398, XP055350546, ISSN: 1864-5631, DOI: 10.1002/cssc.201403478
- MAILOA JONATHAN P ET AL: "A 2-terminal perovskite/silicon multijunction solar cell enabled by a silicon tunnel junction", APPLIED PHYSICS LETTERS, AMERICAN INSTITUTE OF PHYSICS, 2 HUNTINGTON QUADRANGLE, MELVILLE, NY 11747, vol. 106, no. 12, 23 March 2015 (2015-03-23), XP012202604, ISSN: 0003-6951, [retrieved on 19010101], DOI: 10.1063/1.4914179

## Description

### Technical field to which invention relates

The invention relates to the field of solar cells.

The tandem solar cell described in the proposal consists of two solar cells, perovskite and crystalline silicon, with different forbidden energy gaps. These two cells are connected in series, and good contact between them is provided by a semiconductor tunnel junction characterized by low electrical and optical losses.

### Indication of the background art

Viable and environmentally friendly electricity produced by solar cells today is still more expensive than electricity produced from fossil fuels. In order to reduce the cost of solar cells' electricity, the cost of the cells themselves should be lowered and their conversion efficiency should be raised. This can be achieved through improvement and development of new production technologies, new materials and new concepts. The efficiency of currently produced single p-n junction solar cells is still below the theoretical Shockley-Queisser limit. In silicon solar cells, for example, this theoretical limit is 32%, but in practice only 26.1% efficiency is achieved to date.

Inefficient use of the solar radiation spectrum is one of the reasons of low conversion efficiency of semiconductor solar cells. According to the Shockley-Queisser theory, only photons of light having energy equal to a semiconductor forbidden band gap are used effectively; the lower energy photons are not absorbed at all, and the excess energy of the higher energy photons is wasted on the cell heating, and thereby, further reducing its efficiency.

To overcome this shortcoming, several semiconductor solar cells with different forbidden energy gaps are combined in one device, i.e., the multijunction solar cells are developed. Various semiconductor materials, including perovskites, are being investigated for the development of such solar cells. The maximum theoretical efficiency of a tandem two-junction solar cell is 47% under unconcentrated solar exposure of the AM1.5 Global spectrum. In laboratories, however, practical maximum efficiency of 32.8% has been achieved, and in a silicon/perovskite tandem it reaches only 28.0%.

The band gap of silicon is 1.12 eV. When developing a maximum-efficiency tandem with silicon cell at the bottom, the ideal band gap of the upper cell should be within the range of 1.7 - 1.8 eV. Perovskites are especially suitable for this purpose since their forbidden energy gap can be varied from 1.55 eV to 2.3 eV by selecting their appropriate chemical composition.

The biggest problem in the development of a two terminal tandem solar cell lies within the need of creating a proper contact between the two composing solar subcells. The contact should have as low electrical resistance as possible what should result in a minimum of power losses. Mostly, a recombination or a tunnel p-n junction is used to achieve such a low-resistance contact. Key difference between these junctions lies in the current transport mechanism: recombination one involves electrons and holes neutralizing each other, often resulting in energy loss, while tunnel junction utilizes quantum tunneling to move electrons from one subcell to another with minimal energy loss. The latter junction has low electrical resistance and linear current-voltage characteristic. Another requirement for the contact between the subcells: it must be transparent to the photons of solar spectrum that have energy equal to or higher than the band gap of the bottom solar cell.

DONG HOE KIM ET AL: "Niobium Doping Effects on TiO2 Mesoscopic Electron Transport Layer-Based Perovskite Solar Cells", CHEMSUSCHEM, vol. 8, no. 14, 17 April 2015 (2015-04-17), pages 2392-2398, XP055350546, DE, ISSN: 1864-5631, DOI: 10.1002/cssc.201403478 describes the impact of ETL doping (TiO₂ doped with Nb) on the efficiency of a perovskite based solar cell. The disadvantage of the analogue is as follows: heavy doping of thick ETL film reduces the forbidden energy gap of the perovskite and thus leads to a decrease in power conversion efficiency.

ZHENG JIANGHUI ET AL: "Large area efficient interface layer free monolithic perovskite/homo-junction-silicon tandem solar cell with over 20% efficiency", ENERGY & ENVIRONMENTAL SCIENCE, vol. 11, no. 9, 2018, pp. 2432-2443; DOI: 10.1039/C8EE00689J describes a recombination contact between the heavily doped Sip⁺⁺ emitter of the bottom subcell and an electron transport layer (ETL) of the perovskite top subcell. In addition, to meet the recombination conditions, the carriers have to tunnel through the native oxide of Si, the thickness of which strongly influences the contact resistance. Thus, the disadvantages of this analogue are the recombination nature of the contact between the silicon and perovskite subcells and presence of an additional barrier of SiO₂ which the carriers have to pass through: if the SiO₂ layer is too thick, it can hinder charge carrier tunneling, and the contact resistance will be increased.

The closest prior art is a two terminal multijunction solar cell composed of metal halide semiconductor and crystalline silicon and a tunnel junction connecting them which is described, for example, in patent US20160163904 and MAILOA JONATHAN P ET AL: "A 2-terminal perovskite/silicon multijunction solar cell enabled by a silicon tunnel junction", APPLIED PHYSICS LETTERS, AMERICAN INSTITUTE OF PHYSICS, 2 HUNTINGTON QUADRANGLE, MELVILLE, NY 11747, vol. 106, no. 12, 23 March 2015, (2015-03-23), XP012202604, ISSN: 0003-6951, DOI: 10.1063/1.4914179). The known solution is a two terminal tandem solar cell of a layered structure containing a p-n tunnel junction. The tunnel junction here is between the heavily doped Si-p⁺⁺ emitter of the bottom solar cell and Si-n⁺⁺ layer which is formed by depositing heavily doped n⁺⁺ hydrogenated amorphous silicon (a-Si:H) using plasma-enhanced chemical vapor deposition (PECVD).

The disadvantages of this solution are as follows. The n⁺⁺ a-Si:H layer formation requires an additional technological equipment and procedure - PECVD. In addition, it needs annealing in N₂ ambient. Also, to mitigate the interdiffusion of dopant species during the device fabrication, a thin intrinsic a-Si layer needs to be inserted between the p⁺⁺ emitter and the n⁺⁺ amorphous Si layer. All these additional procedures require additional time and labor costs. Furthermore, such a tunnel junction, which has the same forbidden energy gap as the underlying silicon solar cell, absorbs the light photons required for electron and hole pair generation in the bottom silicon solar cell and this way reduces the efficiency of this cell, thus, the total efficiency of the tandem cell is reduced as well.

### Technical problem to be solved

The invention aims to reduce the number of technological operations, time and materials in the production of perovskite/silicon tandem solar cell and to increase its conversion efficiency.

### Disclosure of invention

This is achieved by the proposed two terminal tandem solar cell according to claim 1.

### Advantages of the invention

According to the present invention, the proposed two terminal tandem perovskite/silicon solar cell differs from the analogue in that the connecting structure, a tunnel junction, is created not in the top surface layer of the silicon solar cell, but the tunnel junction is formed between the silicon solar cell and electron transport layer by heavy doping of the surface of the electron transport layer during its deposition. Thus, the production of the tandem perovskite/silicon solar cell involves fewer technological operations and requires less materials, and the tunnel junction being located above the silicon solar cell and having low ohmic resistance in the range of low voltages does not absorb light photons needed to generate electrons and holes in the silicon solar cell beneath.

The invention is explained in detail by a drawing showing the cross section of the tandem perovskite/silicon solar cell with two electrical terminals.

### Example of embodiment of the invention

The two terminal tandem solar cell comprises a multilayer structure composed of bottom electrical terminal 1 having ohmic contact with an electron conductivity (n-type) silicon base 2 on which a hole conductivity heavily doped (p⁺⁺-type) silicon emitter 3 is located. An electron transport layer 4 of electron conductivity (n-type), which is a TiO₂ layer, is positioned on the silicon emitter 3 and is covered with a perovskite layer 5, the surface of which has ohmic contact with the top electrical terminal 6. The bottom surface region of the said electron conductivity (n-type) electron transport TiO₂ layer 4, which is adjacent to the surface of said hole conductivity silicon emitter 3, is additionally heavily doped with donor impurity, which is a niobium (Nb) donor impurity, during the deposition process to obtain an electron conductivity heavily doped (n⁺⁺-type) region 4' of the electron transport layer, this way forming a tunnel junction 7 between the p⁺⁺-type silicon emitter and n⁺⁺-type region 4' of the electron transport layer 4. The tunnel junction 7 formed in the proposed way has low ohmic resistance in the low voltage range and does not absorb light photons needed to generate electrons and holes in the silicon solar cell.

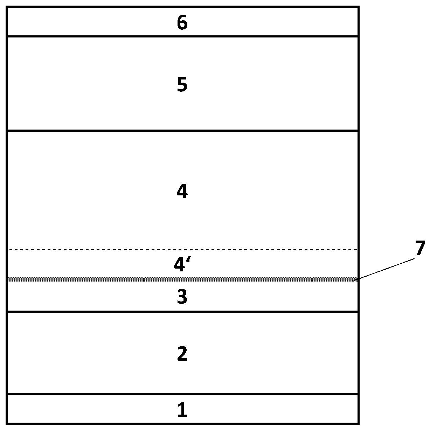

## Claims

1. Two terminal tandem solar cell of a layered structure comprising:
- an electron conductivity crystalline silicon base (2) the bottom surface of which has an ohmic contact with a bottom electrical terminal (1),
- a heavily doped hole conductivity silicon emitter (3) located on said crystalline silicon base (2),
- an electron transport layer (4) deposited on the hole conductivity silicon emitter (3),
- a tunnel junction (7) located between the hole conductivity silicon emitter (3) and the electron transport layer (4),
- a perovskite layer (5) located on the electron transport layer (4), wherein the surface of the perovskite layer (5) has an ohmic contact with a top electrical terminal (6), **characterized in that**
the electron transport layer (4) is of titanium dioxide and the tunnel junction (7) is formed by heavy doping with niobium donor impurity a region (4') of the electron transport layer (4) that is in contact with the surface of said heavily doped hole conductivity silicon emitter (3).

## Patentansprüche

1. Zweipolige Tandemsolarzelle aus Schichtstruktur, umfassend:
- eine kristalline Elektronenleitfähigkeit-Siliziumbasis (2), deren untere Oberfläche einen ohmschen Kontakt mit einem unteren elektrischen Anschluss (1) aufweist,
- einen stark dotierten Lochleitfähigkeit-Siliziumemitter (3), der sich auf der kristallinen Siliziumbasis (2) befindet,
- eine Elektronentransportschicht (4), die auf den Lochleitfähigkeit-Siliziumemitter (3) aufgebracht ist,
- einen Tunnelübergang (7), der sich zwischen dem Lochleitfähigkeit-Siliziumemitter (3) und der Elektronentransportschicht (4) befindet,
- eine Perowskitschicht (5), die sich auf der Elektronentransportschicht (4) befindet, wobei die Oberfläche der Perowskitschicht (5) einen ohmschen Kontakt mit einem oberen elektrischen Anschluss (6) aufweist, **dadurch gekennzeichnet, dass**
die Elektronentransportschicht (4) aus Titandioxid ist und der Tunnelübergang (7) durch starkes Dotieren eines Bereichs (4') der Elektronentransportschicht (4), der mit der Oberfläche des stark dotierten Lochleitfähigkeit-Siliziumemitters (3) in Kontakt ist, mit Niob-Donor-Verunreinigung gebildet wird.

## Revendications

1. Cellule solaire en tandem à deux terminaux d'une structure en couches comprenant :
- une base en silicium cristallin à conductivité d'électrons (2) dont la surface inférieure a un contact ohmique avec un terminal électrique inférieur (1),
- un émetteur en silicium à conductivité de trou fortement dopé (3) situé sur ladite base en silicium cristallin (2),
- une couche de transport d'électrons (4) déposée sur l'émetteur en silicium à conductivité de trou (3),
- une jonction tunnel (7) située entre l'émetteur en silicium à conductivité de trou (3) et la couche de transport d'électrons (4),
- une couche de pérovskite (5) située sur la couche de transport d'électrons (4), dans laquelle la surface de la couche de pérovskite (5) présente un contact ohmique avec un terminal électrique supérieur (6), **caractérisée en ce que**
la couche de transport d'électrons (4) est en dioxyde de titane et la jonction tunnel (7) est formée par dopage lourd avec une impureté de donneur de niobium d'une région (4') de la couche de transport d'électrons (4) qui est en contact avec la surface dudit émetteur de silicium à conductivité de trou fortement dopé (3).
